# EUROPÄISCHE PATENTSCHRIFT

(11) **EP 0 581 139 B1**
(45) Veröffentlichungstag und Bekanntmachung des Hinweises auf die Patenterteilung: **17.09.1997**
(21) Anmeldenummer: 93111420.1
(22) Anmeldetag: 16.07.1993
(51) Int. Cl.: G06F 1/18, H05K 7/14

(54) **Platinenanordnung für Computer oder ähnliche elektronische Geräte**
Circuit board arrangement for computers or similar electronic devices
Arrangement de cartes d'un ordinateur ou d'un appareil similaire

(30) Priorität: 25.07.1992 DE 4224656
(43) Veröffentlichungstag der Anmeldung: 02.02.1994
(73) Patentinhaber: ICOS Gesellschaft für Industrielle Communications Systeme mbH, D-40549 Düsseldorf (DE)
(72) Erfinder: Stäcker, Hans-Joachim, Dipl.-Ing., D-40789 Monheim (DE); Russ, Peter Johannes, Dipl.-Ing., D-41564 Kaarst (DE)
(74) Vertreter: Koscholke, Gotthold, Dr.-Ing.

(56) Entgegenhaltungen:
- EP-A- 0 438 014
- US-A- 4 575 780
- US-A- 5 038 308
- IBM TECHNICAL DISCLOSURE BULLETIN. Bd. 33, Nr. 2 , Juli 1990 , NEW YORK US Seiten 103 - 105 XP000123550 'Adaptable card retainer'

## Beschreibung

Die Erfindung bezieht sich auf eine Platinen-Anordnung für Computer und ähnliche elektronische Geräte nach dem Oberbegriff des Anspruchs 1.

Bei einer bekannten Einrichtung zur mechanischen Sicherung von Steckkarten in einem Computergehäuse od.dgl. (DE-GM 90 03 412) lassen sich Steckkarten parallel zueinander und im rechten Winkel zu einer Wand anordnen, die Steckleisten als sog. BUS-Anschlüsse tragen kann. An ihrer dieser Wand gegenüberliegenden Kante wird die Steckkarte mechanisch durch eine Klauenhalterung mit einem Haltestück abgestützt, das ein die Kante umgreifendes Profil hat und entweder an einer Gehäusewand angebracht oder durch einen Bügel gestützt ist. Mit weiteren Haltestücken kann die Steckkarte auch an der Vorderwand und der Rückwand des Gehäuses abgestützt sein. Damit wird angestrebt, die Steckkarten in ihrer Lage zu sichern und nachteilige Einflüsse beim Transport oder durch Vibrationen eines Laufwerks möglichst gering zu halten.

Aus der EP-A-0 438 014 ist weiterhin eine Gehäusekonstruktion zur Unterbringung und Halterung von Komponenten eines Computers bekannt, die Seitenwände, eine mit diesen verbundene Mittelplatine und zu jeder Seite der letzteren Führungsteile zur Aufnahme von Logikelementen aufweist.

Die Mittelplatine ist auf jeder Seite mit vertikalen Anschlußleisten versehen, mit denen die Logikelemente verbunden werden können. Die Anschlußleisten sind auf der Mittelplatine so angeordnet, daß ihre oberen und unteren Enden jeweils miteinander fluchten, d.h. auf einer Linie liegen.

Aufgabe der Erfindung ist es, eine Platinen-Anordnung für Computer od.dgl. zu schaffen, die eine kompakte Bauweise mit hoher Packungsdichte der Bauteile ermöglicht, so daß eine große elektronische Leistung in relativ geringem Volumen untergebracht werden kann. Die Anordnung soll es dabei außerdem gestatten, die Platinen so festzulegen, daß auch hohen Anforderungen an Schwingungsfreiheit und an die Stabilität des Gesamtaufbaues genügt werden kann. Die Erfindung strebt ferner eine vorteilhafte Ausbildung der Anordnunq und ihrer Teile im einzelnen an. Weitere mit alledem zusammenhängende Probleme, mit denen sich die Erfindung befaßt, ergeben sich aus der jeweiligen Erläuterung der aufgezeigten Lösung.

Die Aufgabe wird erfindungsgemäß durch eine Platinenanordnung nach Anspruch 1 gelöst. Vorteilhafte Weiterbildungen finden sich in den Unteransprüchen.

Bei einer Anordnung der eingangs genannten Art sieht die Erfindung vor, daß wenigstens auf einer Seite der Bus-Platine wenigstens eine Steckleiste für eine Platine in einem Halbbereich (in einer Hälfte) dieser Plattenseite und wenigstens eine Steckleiste für eine andere Platine in dem anderen Halbbereich (in der anderen Hälfte) dieser Plattenseite angeordnet ist, wobei die Halbbereiche der Bus-Platine - in Richtung der Steckleisten gesehen - nebeneinander liegen, und daß die Steckleisten in dem einen Halbbereich der Plattenseite und die Steckleisten in dem anderen Halbbereich in Höhenrichtung der Bus-Platine zueinander versetzt sind.

Die Bus-Platine ist dabei mit zu den Steckleisten führenden Leiterbahnen versehen, so wie es die Funktion einer Bus-Platine erfordert. Unter den Ausdrücken "Steckleiste" einerseits und "Kontaktleiste" andererseits sind dabei grundsätzlich die Teile einer Steckverbindung zu verstehen, die dazu dient, einen elektrischen Kontakt zwischen einem Leiter an einem Element und einem Leiter an einem anderen Element herzustellen, zweckmäßig zugleich mit Erzielung einer mechanischen Haltewirkung. Solche Steckverbindungen stehen dem Fachmann in geeigneten Ausführungen zur Verfügung.

Dadurch, daß die Bus-Platine auf jeder ihrer beiden Plattenseiten Platinen aufnehmen kann, ergibt sich bereits die vorteilhafte Möglichkeit, ein zur Verfügung stehendes Volumen sehr gut auszunutzen bzw. die für ein Gerät benötigten Bauteile raumsparend unterzubringen. Zu einer besonders günstigen Raumausnutzung und kompakten Bauweise führt hierbei die zusätzliche Maßnahme, Steckleisten auf einer Plattenseite der Bus-Platine teils in der einen und teils in der anderen Hälfte dieser Plattenseite und in Höhenrichtung versetzt zueinander anzuordnen. Es lassen sich dann z.B. Platinen unterschiedlicher Länge so einsetzen, daß der von einer Platine nicht eingenommene Raum genutzt werden kann, indem auf der benachbarten Platine befindliche elektronische Elemente oder Bauteile sich in diesen Raum hinein erstrecken können. Dies kann bei verschiedenen Platinenabmessungen der Fall sein, sowohl bei einer Kombination, bei der eine Platine verhältnismäßig lang ist, etwa die maximal mögliche Länge hat, während die benachbarte Platine kürzer ist, als besonders auch bei zwei einander benachbarten verhältnismäßig kurzen Platinen, z.B. solchen, deren Länge nur die Hälfte oder zwei Drittel der unter den jeweiligen Gegebenheiten maximal möglichen Länge haben.

Die Ausführung läßt sich so treffen, daß die erläuterte Anordnung von Steckleisten in dieser Form nur auf einer Plattenseite der Bus-Platine vorgesehen und auf der anderen Plattenseite der Bus-Platine eine andere Anordnung gewählt wird. Ungeachtet dessen, also bei im Prinzip gleicher oder unterschiedlicher Anordnung von Steckleisten auf beiden Plattenseiten, sind zweckmäßig Steckleisten auf der einen Plattenseite der Bus-Platine zu Steckleisten auf der anderen Plattenseite der Bus-Platine in Höhenrichtung der Bus-Platine zueinander versetzt angeordnet.

Stattdessen oder aber auch in Kombination mit einer solchen Anordnung läßt sich die Ausführung so treffen, daß wenigstens eine Steckleiste auf der einen Plattenseite der Bus-Platine zumindest annähernd auf gleicher Höhe mit wenigstens einer Steckleiste auf der anderen Plattenseite der Bus-Platine angeordnet ist. Bei einer vorteilhaften Ausführung sind dabei die zumindest annähernd auf gleicher Höhe auf den beiden Plattenseiten der Bus-Platine angeordneten Steckleisten in verschiedenen Hälften der beiden Plattenseiten der Bus-Platine vorgesehen, d.h. auf der einen Plattenseite nach dem einen Ende der Bus-Platine hin und auf der anderen Plattenseite nach deren anderem Ende hin.

Die Ausbildung läßt sich so vornehmen, daß zumindest ein Teil der Steckleisten in einer Hälfte der Plattenseite der Bus-Platine einen größeren Abstand von einem Rand der Bus-Platine hat als zumindest ein Teil der Steckleisten in der anderen Hälfte derselben Plattenseite der Bus-Platine von dem selben Rand der Bus-Platine. Dies ermöglicht eine günstige gestaffelte Anordnung.

Gemäß einem weiteren Merkmal der Erfindung weist die Bus-Platine außer den Steckleisten wenigstens eine als Nutleiste od.dgl. ausgebildete Halterung für den Rand einer Platine auf. Zweckmäßig ist eine solche Halterung etwa in der gleichen Ebene wie eine Steckleiste vorgesehen. Dadurch läßt sich eine Platine an demselben Rand, an dem sich die Steckverbindung befindet, auch im übrigen Bereich dieses Randes festlegen. Je nach der Art und Größe der betreffenden Platine kann stattdessen oder zusätzlich an der Bus-Platine wenigstens eine Halterung in einer zur Ebene einer Steckleiste versetzten Ebene vorgesehen sein.

Ein vorteilhafte Ausführung besteht darin, daß auf einer Plattenseite der Bus-Platine wenigstens eine Halterung in einem Bereich vorgesehen ist, in dem sich auf der anderen Plattenseite der Bus-Platine eine Steckleiste befindet.

Gemäß einem besonderen Merkmal der Erfindung sind zumindest einige der bei dem betreffenden Computer oder sonstigen elektronischen Gerät vorhandenen Platinen an einem der Bus-Platine abgewandten Rand durch Halteschuhe abstützbar, die in Führungen von übereinander angeordneten Fixierschienen verschiebbar sind. Für die Ausbildung der Halteschuhe bestehen im einzelnen zahlreiche Möglichkeiten. Eine zweckmäßige Ausführung wird noch erläutert werden. Die Fixierschienen sind in der jeweiligen Bedarfsposition relativ zur Grundplatte lösbar festlegbar, wobei sie sich unmittelbar aneinander oder über zwischengelegte Abstandsstücke stapelartig abstützen. Hierdurch ergibt sich ein steifer blockartiger Aufbau, in dem die Platinen sicher gehalten sind.

Die Fixierschienen sind bei einer vorteilhaften Ausführung an ihren Enden lösbar mit auf der Grundplatte befestigten Stützböcken verbunden. Zweckmäßige Ausgestaltungen solcher Stützböcke werden im einzelnen noch erläutert.

Zur weiteren Erhöhung der Steifigkeit können die Fixierschienen an einer oder mehrerer Stellen im Bereich zwischen ihren Enden, ggfs. zusammen mit dort vorhandenen Abstandsstücken, mit der Grundplatte verspannbar sein. Eine geeignete Spannvorrichtung wird später noch beschrieben.

In weiterer Ausgestaltung der Erfindung ist vorgesehen, daß wenigstens eine Fixierschiene einen quer von ihr abstehenden Arm aufweist, der mit einer Halterung für einen weiteren Rand einer Platine versehen ist oder eine solche bildet. Hierdurch ist in unkomplizierter Weise und ohne Inanspruchnahme anderer Bauelemente die betreffende Platine auch an einem weiteren Rand eingespannt. Eine solche oder auch eine andere Halterung läßt sich für den vierten Rand einer z.B. rechteckigen Platine vorsehen.

Weitere Einzelheiten, Merkmale und Vorteile der Erfindung ergeben sich aus der nachstehenden Erläuterung von Ausführungsbeispielen, aus der zugehörigen Zeichnung und aus den Ansprüchen. Es zeigen:
- Fig. 1: eine perspektivische Ansicht eines gemäß der Erfindung ausgebildeten Computers mit abgenommenen Gehäuse- bzw. Abdeckteilen,
- Fig. 2: eine Draufsicht auf einen Teil der Platinen-Anordnung eines Computers, ähnlich demjenigen in Fig. 1,
- Fig. 3: einen Querschnitt durch eine Platinen-Anordnung, im Prinzip nach der Linie III-III in Fig. 2, jedoch etwas abgewandelt,
- Fig. 4: eine Fixierschiene im Schnitt nach der Linie IV-IV in Fig. 5 mit einem Halteschuh,
- Fig. 5: eine Ansicht der Fixierschiene nach Fig. 4,
- Fig. 6: eine Seitenansicht des in Fig. 4 in Draufsicht gezeigten Halteschuhes,
- Fig. 7: einen Stützbock in Ansicht,
- Fig. 8: eine Stirnansicht zu Fig. 7,
- Fig. 9: eine Draufsicht zu Fig. 7 und
- Fig. 10: eine Bus-Platine in schematischer Darstellung.

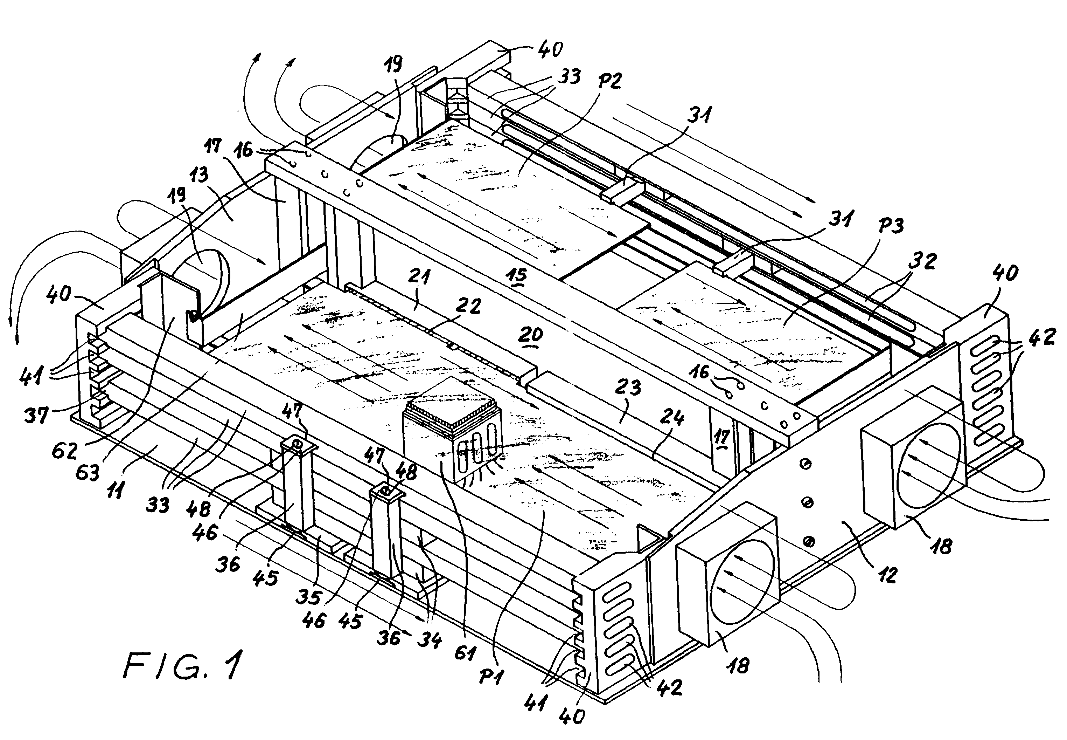

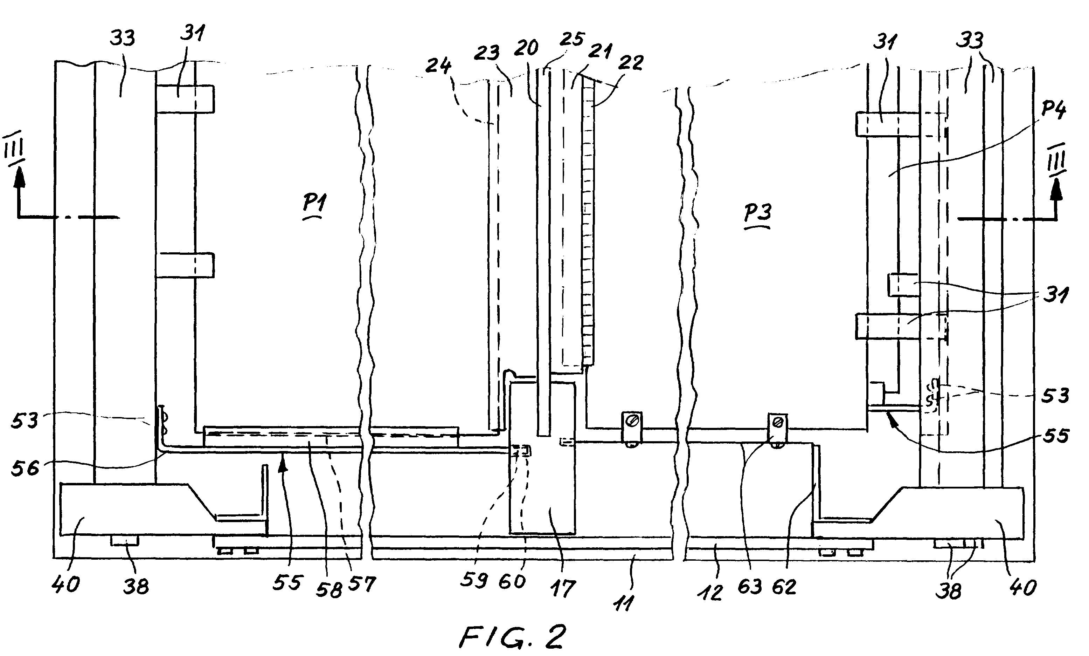

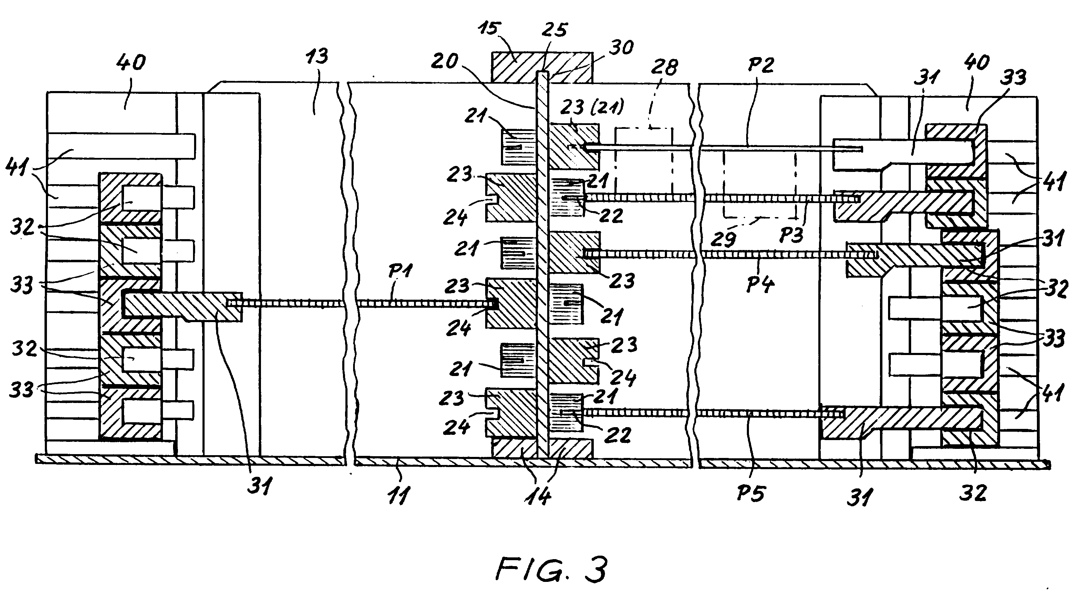

Bei dem in den Figuren 1 bis 3 dargestellten Gerät handelt es sich insbesondere um einen Industrie-Computer, der bei seinem Einsatz auch äußeren mechanischen Beanspruchungen, wie Stößen und Erschütterungen, standhalten muß. Seine mit elektronischen Elementen bestückten Platinen (Karten, Boards usw.) P1 bis P5 sind in einem stabilen Chassis untergebracht, das u.a. eine starre Grundplatte 11, zwei mit dieser verbundene Stirnwände 12 und 13, zwei auf der Grundplatte 11 befestigte, sich zwischen den Stirnwänden erstreckende Balken 14 (Fig. 3) sowie eine die Stirnwände 12, 13 in einem Abstand von der Grundplatte miteinander verbindende Traverse 15 aufweist. Diese ist im Bereich ihrer Enden durch Schrauben 16 mit Konsolen 17 verbunden, die ihrerseits an den Balken 14 und/oder an der Grundplatte 11 mit Schrauben befestigt sind. Dies stellt eine rahmenartige Anordnung dar, in der eine Bus-Platine 20 fest eingespannt ist. Wie aus den Figuren 2 und 3 erkennbar ist, wird die Bus-Platine 20 dabei an ihrem unteren Rand durch die beiderseits an ihr anliegenden Balken 14 gehalten. Mit ihren seitlichen Rändern greift die Bus-Platine 20 in Nuten der Konsolen 17 ein, während sie an ihrem oberen Rand auf der ganzen Länge in einer Nut 30 der Traverse 15 gehalten ist. In Figur 2 ist die Anordnung mit abgenommener Traverse 15 gezeigt.

Die Bus-Platine 20 ist auf ihren beiden Plattenseiten mit Aufnahmeteilen von Steckverbindungen versehen, die hier allgemein als Steckleisten bezeichnet werden und in die jeweils das Gegenstück der betreffenden Steckverbindung, das hier allgemein mit Kontaktleiste benannt wird, eingeführt werden kann. In der Zeichnung sind Steckleisten mit der Zahl 21 und Kontaktleisten mit der Zahl 22 bezeichnet.

Um die jeweilige Platine an dem Rand, an dem sich die Kontaktleiste 22 befindet, weiterhin in ihrer Lage zu sichern, sind an der Bus-Platine 20 zusätzliche Halterungen angebracht, die bei der gezeigten Ausführung die Form von Nutleisten 23 haben. Es handelt sich um leistenförmige Körper, die auf ihrer der Bus-Platine abgewandten Seite jeweils eine Nut 24 aufweisen, in welche sich der Rand der betreffenden Platine passend einfügen kann.

Für die Anordnung der Steckleisten 21 an der Bus-Platine bestehen zahlreiche Möglichkeiten, so daß vielfältigen Anforderungen leicht Rechnung getragen werden kann. Selbstverständlich werden je nach der Anordnung der Steckleisten auch die erforderlichen Leiterbahnen auf bzw. in der ggfs. mehrlagigen Bus-Platine so vorgesehen, daß die Funktion der Bus-Platine in der gewünschten Weise gegeben ist. Dies stellt kein Problem dar.

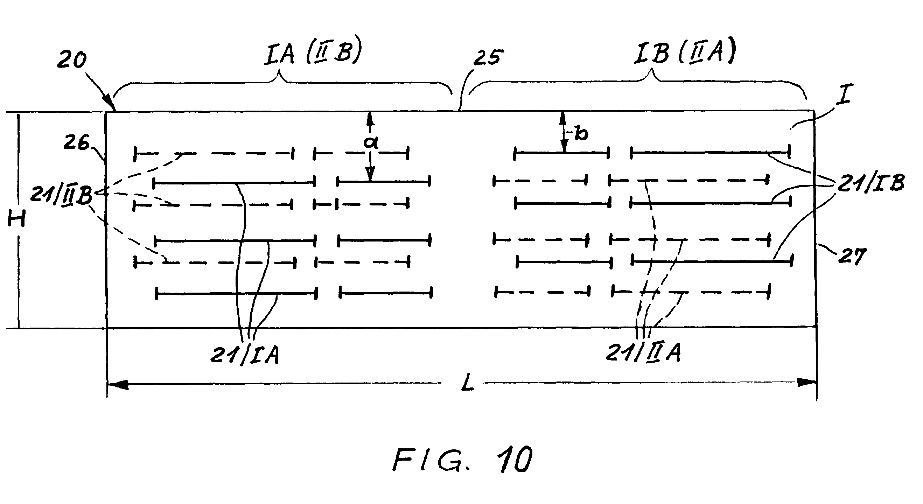

Eine vorteilhafte Ausführung einer Bus-Platine 20 ist teils schematisch in Figur 10 wiedergegeben. Die Bus-Platine hat die Höhe H und die Länge L. Die in Figur 10 sichtbare Plattenseite der Bus-Platine sei mit I und die andere Plattenseite mit II bezeichnet. Auf jeder Plattenseite lassen sich zwei Hälften oder Halbbereiche unterscheiden, von denen der in der jeweiligen Ansicht linke Bereich mit dem Buchstaben A und der rechte Bereich mit dem Buchstaben B bezeichnet ist. Die Steckleisten 21 sind jeweils durch Linienzüge schematisch angedeutet, und zwar für die Plattenseite I mit ausgezogenen Linien und für die Plattenseite II mit gestrichelten Linien. Die Anordnung ist so getroffen, daß sich jeweils auf der Plattenseite I drei Steckleisten 21 im Halbbereich IA und drei Steckleisten 21 im Halbbereich IB befinden, wobei die Steckleisten im Halbbereich IB relativ zu den Steckleisten im Halbbereich IA in der Höhe versetzt sind, untereinander jedoch den gleichen Abstand haben.

Das Entsprechende gilt für die Plattenseite II. Denkt man sich in Figur 10 die Bus-Platine 20 umgedreht, d.h. um eine ihrer kurzen Kanten um 180° geschwenkt, so ergibt sich das gleiche Bild wie auf der Plattenseite I. Dies bedeutet, daß sich an der Stelle, die im Halbbereich A der Plattenseite I nicht von einer Steckleiste 21 besetzt ist, auf der anderen Plattenseite II (dort im Halbbereich IIB) eine Steckleiste befindet. Dabei ist auch das Merkmal erfüllt, daß eine Steckleiste 21 /IA bzw. 21/IB auf der einen Plattenseite I auf gleicher Höhe mit einer Steckleiste 21/IIA bzw. 21/IIB auf der anderen Plattenseite II angeordnet ist.

Dieses Beispiel veranschaulicht zugleich auch das Merkmal, daß Steckleisten 21/IA, 21/IB auf der einen Plattenseite I zu Steckleisten 21/IIA, 21/IIB auf der anderen Plattenseite II in Höhenrichtung H der Bus-Platine 20 zueinander versetzt sind.

Bei der in Figur 10 gezeigten Ausführung ist es außerdem noch so, daß die Steckleisten 21/IA in einem Halbbereich A der einen Plattenseite I einen größeren Abstand a vom oberen Rand 25 der Bus-Platine 20 haben als die Steckleisten 21/IB in dem anderen Halbbereich B derselben Plattenseite I, wo der Abstand mit b bezeichnet ist. Dies kann in zahlreichen Fällen von besonderem Nutzen sein.

Wie aus Figur 10 ferner ersichtlich ist, sind die Abstände der Steckleisten, z.B. 21/IA, 21/IB von den seitlichen Kanten 26, 27 der Bus-Platine 20 unterschiedlich. Dies bietet in günstiger Weise auch die Möglichkeit stirnseitige Steckverbindungen an den Stirnseiten der Platinen unterzubringen.

Mit den verschiedenen genannten Merkmalen ist eine Vielfalt von Ausbildungsmöglichkeiten gegeben, so daß unterschiedliche Anforderungen erfüllt werden können.

An denjenigen Partien in einem Halbbereich A bzw. B, an denen sich keine Steckleiste befindet, während im anderen Halbbereich B bzw. A derselben Plattenseite eine solche angebracht ist, lassen sich vorteilhaft Nutleisten 23 als zusätzliche Halterung für den betreffenden Rand der Platine vorsehen, worauf weiter oben schon hingewiesen wurde. Denkt man sich in Figur 10 die gestrichelten Linien nicht als Steckverbindungen auf der anderen Plattenseite II, sondern als Nutleisten auf derselben Plattenseite I, so ergibt sich eine besonders vorteilhafte Ausführung. Auf der anderen Plattenseite II kann es ebenso oder auch anders sein.

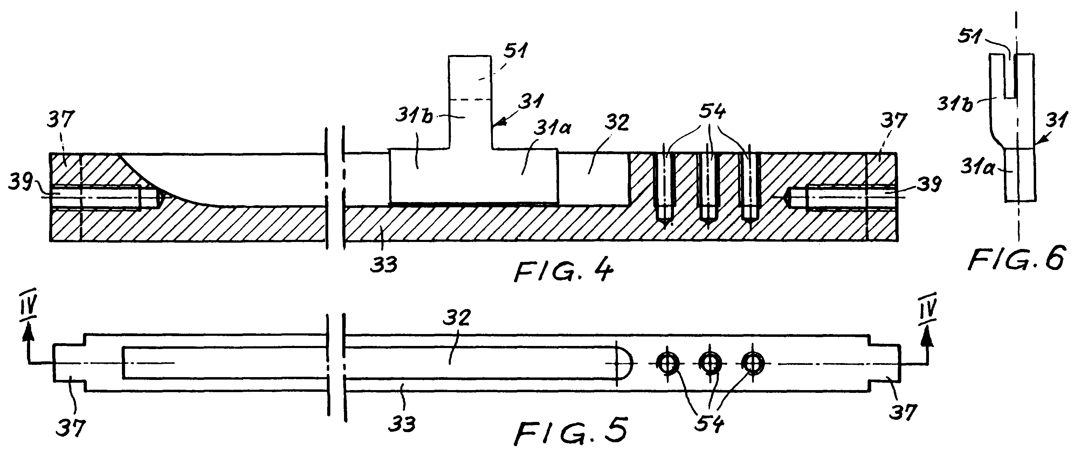

Die einzelnen Platinen sind an ihrem der Bus-Platine 20 abgewandten Rand ebenfalls gehalten und abgestützt. Dazu sind bei der gezeigten vorteilhaften Ausführung Halteschuhe 31 vorgesehen, die in Führungsnuten 32 von Fixierschienen 33 (s. auch Figur 4) verschiebbar sind und dadurch an den gewünschten Stellen positioniert werden können. Wie besonders die Figuren 1 und 3 erkennen lassen, sind die Fixierschienen 33 stapelartig übereinander angeordnet, wobei sie sich unmittelbar aneinander oder mit zwischengelegten Abstandsstücken 34 gegenseitig abstützen und insgesamt auf der Grundplatte 11 aufliegen oder, wie bei diesem Ausführungsbeispiel auf Basisteilen 35 von Spannvorrichtungen 36 aufruhen.

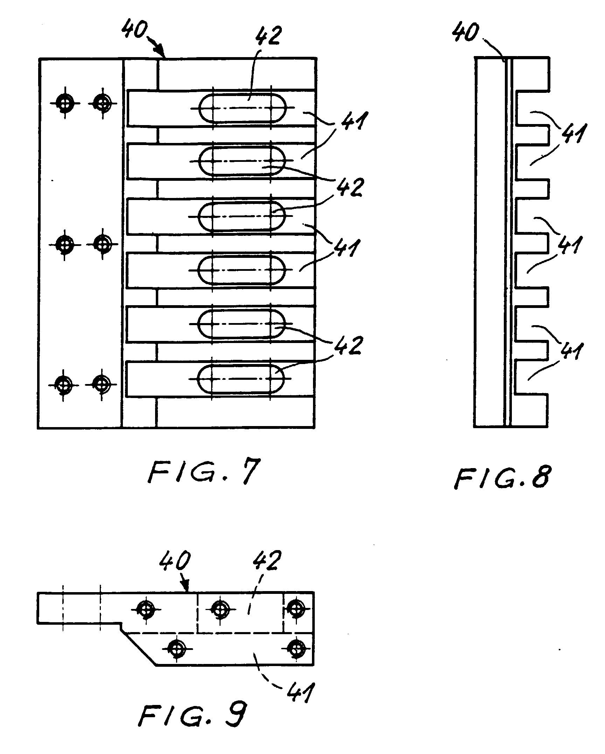

An ihren Enden sind die Fixierschienen 33 lösbar in Stützböcken 40 gehalten, die durch Schrauben oder auf andere geeignete Weise starr mit der Grundplatte 11 verbunden sind. Jeder Stützbock 40 weist eine Anzahl von parallelen Haltenuten 41 auf. In diesen sind stufenartig abgesetzte Enden 37 der Fixierschienen 33 verschiebbar, derart, daß die Position der Fixierschienen innerhalb eines gewissen Bereichs so gewählt werden kann, wie es die jeweiligen Erfordernisse verlangen, insbesondere in Anpassung an die Breite der zu halternden Platine. In der eingestellte Position wird die Fixierschiene 33 durch Schrauben 38 (Fig. 2) eingespannt und gesichert, die in stirnseitige Gewindebohrungen 39 der Fixierschienen 33 eingeschraubt werden. Die Schrauben 38 (in Figur 1 nicht eingezeichnet) gehen dabei durch Langlöcher 42 hindurch, die sich an den Stellen der Nuten 41 jeweils am Grund derselben befinden (Figuren 1 und 7, in Figur 3 nicht eingezeichnet).

Die Fixierschienen 33 können an einer oder mehreren Stellen im Bereich zwischen ihren Enden zusätzlich mit der Grundplatte 11 verspannt sein. Eine Ausführung dazu zeigt Figur 1 im linken Teil. Es sind zwei weiter oben schon erwähnte Spannvorrichtungen 36 vorhanden, deren plattenartige Fußstücke in T-Nuten 45 der Basisteile 35 verschiebbar sind. Spannpratzen 46 der Spannvorrichtungen greifen in Ausnehmungen 47 der obersten Fixierschiene 33 ein. Mittels einer die Vorrichtung durchsetzenden Schraube 48, die in ein Gewinde im Fußstück eingeschraubt ist, wird die Verspannung bewirkt.

Die Halteschuhe 31 haben bei der gezeigten Ausführung eine T-förmige Grundgestalt, wobei der T-Balken 31a den von der Führung 32 der Fixierschiene 33 aufgenommenen Teil bildet und der Schenkel 31b am freien Ende eine zum Übergreifen des Randes einer Platine geeignete Nut oder Ausnehmung 51 aufweist (Fig. 6). Diese Ausnehmung kann, wie gezeigt, insbesondere unsymmetrisch zur Mittelebene M des durch den T-Balken 31a gebildeten Führungsteiles liegen, derart, daß sich durch Umsetzen des Halteschuhes 31 um 180° in der Führung 32 der Fixierschiene 33 unterschiedliche Positionen der Ausnehmung 51 mit Bezug auf die Fixierschiene 33 ergeben. Dies ist ist in Figur 1 bei den Halteschuhen 31 für die Platinen P2 und P3 zu sehen.

Wie Figur 2 erkennen läßt, kann an einer oder mehreren Fixierschienen 33 ein quer von ihr abstehender Arm 55 befestigt sein, der mit einer Halterung für einen weiteren Rand einer Platine P1 versehen ist oder eine solche bildet. Bei der gezeigten Ausführung hat der Arm 55 die Form eines an der Fixierschiene 33 mit Schrauben 53 befestigten Winkelstückes 56 mit einem eine Nut 57 aufweisenden Haltekörper 58. Mit seinem Ende 59 greift das Winkelstück 56 des Armes 55 in eine passende Öffnung oder Ausnehmung 60 der Konsole 17 ein, so daß er dadurch auch an diesem Ende abgestützt ist.

Wie die Figuren 4 und 5 zeigen, können die Fixierschienen 33 mehrere Gewindebohrungen 54 für die Schrauben 53 zur Befestigung eines Armes 55 aufweisen, so daß hierdurch eine Einstellbarkeit zur Anpassung an die jeweiligen Gegebenheiten besteht.

Bei der im rechten Teil der Figur 2 erkennbaren Platine P3 kann ein solcher Arm am nicht sichtbaren Ende derselben vorgesehen sein. An dem gezeigten Ende ist die Platine P3 in üblicher Weise mit einem Anschlußblech 63 verbunden, das über einen Winkel 62 an dem benachbarten Stützbock 40 angeschraubt ist. In Figur 1 ist dies auch bei der Platine P1 an deren der Stirnwand 13 benachbarten Ende zu sehen. Auf die beschriebene Weise ist es möglich, eine Platine an allen Rändern sicher festzulegen.

Die in den Figuren 1 bis 3 wiedergegebenen Ausführungen stimmen im Grundsätzlichen überein. Lediglich zur besseren Veranschaulichung bestehender Möglichkeiten sind hinsichtlich der aufgenommenen Platinen einige Unterschiede vorhanden.

Im rechten Teil der Figur 1 sind zwei verhältnismäßig kurze Platinen P2 und P3 gezeigt, die in verschiedenen Höhen angeordnet sind, wie sich auch an den dabei benutzten beiden Fixierschienen 33 erkennen läßt. Dabei können auf der Oberseite der Platine P3 befindliche elektronische Elemente noch oben in den von der Platine P2 nicht eingenommenen Raum hineinragen, während andererseits an der Unterseite der Platine P2 vorgesehene Elemente in den von der Platine P3 freigelassenen Raum vorstehen können. In Figur 3 ist dies bei im übrigen etwas abgewandelter Anordnung gezeigt, wobei jeweils mit strichpunktierten Linien ein oberseitig auf der Platine P3 befindliches Element 28 und ein unten von der Platine P2 abstehendes Element 29 angedeutet sind.

In der rechten Hälfte der Figur 3 ist veranschaulicht, daß die Fixierschienen 33 in horizontaler Richtung mit unterschiedlichen Abstände zur Bus-Platine 20 einstellbar sind, je nachdem, wie es die zu halternden Platinen erfordern, und daß zu diesem Zweck auch die Halteschuhe 31 unterschiedlich lang sein können (vgl. den untersten Halteschuh).

Figur 2 läßt auf der rechten Seite in Draufsicht erkennen, wie sich Platinen P3 und P4 unterschiedlicher Breite festlegen lassen. Als Beispiel ist dabei außerdem gezeigt, daß die Platine P3 an ihrem hier dargestellten Ende mittels einer schon erwähnten, üblichen Halterung durch einen Winkel 62 an der Konsole 17 festgelegt ist, während eine darunter befindliche Platine P4 an dem betreffenden Rand durch einen an der zugehörigen Fixierschiene angeschraubten Arm 55 mit Haltekörper 58 eingespannt ist.

Zur Abführung von Wärme bestehen bei der Platinen-Anordnung die verschiedensten Möglichkeiten, so daß auch in dieser Hinsicht allen Anforderungen genügt werden kann. Als Beispiel zeigt Figur 1 zwei an der Stirnwand 12 vorgesehene Kühlluft-Gebläse 18 und zwei Luftaustritts-Öffnungen 19, wobei die Luftströme mit dünnen Pfeil-Linien angedeutet sind. Es können auch in der Stirnwand 13 Kühlluft-Gebläse vorgesehen sein, wobei dann eine oder mehrere Luftaustritts-Öffnungen an anderer Stelle vorhanden sein können.

Weiterhin können zur Wärmeabführung zwischen elektronischen aktiven Bauteilen und einem wärmeaufnehmenden bzw. wärmeabstrahlenden Teil der Anordnung sog. Kühlkissen, Wärmeübertragungsbeutel od.dgl. vorgesehen werden wie sie an sich bekannt sind. Als Beispiel ist in Figur 1 ein zwischen der Platine P1 bzw. einem wärmeabgebenden Bauteil auf dieser und der Grundplatte 11 eingesetzter Kühl- oder Wärmeübertragungskörper 61 gezeigt, wobei die kleinen Pfeile die Abführung der Wärme in die Grundplatte andeuten.

## Patentansprüche

1. Platinen-Anordnung für Computer und ähnliche elektronische Geräte, wobei die mit jeweils wenigstens einer Kontaktleiste (22) an einem Rand ausgerüsteten Platinen (P1, P2, P3, P4, P5) sich quer zu einem Plattenbauteil (20) erstrecken, das seinerseits orthogonal zu einer Grundplatte und relativ zu dieser feststehend angeordnet ist und eine Bus-Platine bildet, die auf jeder Seite Steckleisten (21) für die Kontaktleisten (22) der Platinen (P1, P2, P3, P4, P5) aufweist, gekennzeichnet durch folgende Merkmale:
- wenigstens auf einer Plattenseite (I bzw. II) der Bus-Platine (20) ist wenigstens eine Steckleiste (21) für eine Platine (P1, P2, P3, P4, P5) in einem Halbbereich (IA oder IB bzw. IIA oder IIB) dieser Plattenseite (I bzw. II) und wenigstens eine Steckleiste (21) für eine andere Platine (P1, P2, P3, P4, P5) in dem anderen Halbbereich (IA oder IA bzw. IIB oder IIA) dieser Plattenseite (I bzw. II) angeordnet,
- wobei die Halbbereiche (IA, IB bzw. IIA, IIB) der Bus-Platine (20) - in Richtung der Steckleisten (21) gesehen - nebeneinanderliegen,
- die Steckleisten (21) in dem einen Halbbereich (IA bzw. IIA) der Plattenseite (I bzw. II) und die Steckleisten (21) in dem anderen Halbbereich (IB bzw. IIB) sind in Höhenrichtung (H), die senkrecht zur Richtung der Steckleisten verläuft, der Bus-Platine (20) zueinander versetzt.

2. Anordnung nach Anspruch 1, dadurch gekennzeichnet, daß Steckleisten (21) auf der einen Plattenseite (I bzw. II) der Bus-Platine (20) zu Steckleisten (21) auf der anderen Plattenseite (II bzw. I) der Bus-Platine (20) in Höhenrichtung (H) der Bus-Platine (20) zueinander versetzt sind.

3. Anordnung nach Anspruch 1 oder 2, dadurch gekennzeichnet, daß wenigstens eine Steckleiste (21) auf der einen Plattenseite (I bzw. II) der Bus-Platine (20) zumindest annähernd auf gleicher Höhe mit wenigstens einer Steckleiste (21) auf der anderen Plattenseite (II bzw. I) der Bus-Platine (20) angeordnet ist.

4. Anordnung nach Anspruch 3, dadurch gekennzeichnet, daß die zumindest annähernd auf gleicher Höhe auf den beiden Plattenseiten (I, II) der Bus-Platine (20) angeordneten Steckleisten (21) in verschiedenen Halbbereichen (A, B) der beiden Plattenseiten (I, II) der Bus-Platine (20) vorgesehen sind.

5. Anordnung nach einem der Ansprüche 1 bis 4, dadurch gekennzeichnet, daß zumindest ein Teil der Steckleisten (21) in einem Halbbereich (A) einer Plattenseite (I) der Bus-Platine (20) einen größeren Abstand (a) von einem Rand (25) der Bus-Platine (20) hat als zumindest ein Teil der Steckleisten (21) in dem anderen Halbbereich (B) derselben Plattenseite (I) der Bus-Platine (20) von demselben Rand (25) der Bus-Platine (20).

6. Anordnung nach einem der Ansprüche 1 bis 5, dadurch gekennzeichnet, daß die Bus-Platine (20) außer den Steckleisten (21) wenigstens eine als Nutleiste ausgebildete Halterung (23) für den Rand einer Platine (P1, P2, P3, P4, P5) aufweist.

7. Anordnung nach Anspruch 6, dadurch gekennzeichnet, daß an der Bus-Platine (20) wenigstens eine Halterung (23) etwa in der gleichen Ebene wie eine Steckleiste (21) vorgesehen ist.

8. Anordnung nach Anspruch 6, dadurch gekennzeichnet, daß an der Bus-Platine (20) wenigstens eine Halterung (23) in einer zur Ebene einer Steckleiste (21) versetzten Ebene vorgesehen ist.

9. Anordnung nach einem der Ansprüche 6 bis 8, dadurch gekennzeichnet, daß auf einer Plattenseite (I bzw II) der Bus-Platine (20) wenigstens eine Halterung (23) in einem Bereich vorgesehen ist, in dem sich auf der anderen Plattenseite (II bzw. I) der Bus-Platine (20) eine Steckleiste (21) befindet.

10. Anordnung nach einem der Ansprüche 1 bis 9, dadurch gekennzeichnet, daß zumindest einige der vorhandenen Platinen (P1, P2, P3, P4, P5) an einem der Bus-Platine (20) abgewandten Rand durch Halteschuhe (31) abstützbar sind, die in Führungen (32) von übereinander angeordneten Fixierschienen (33) verschiebbar sind, welche sich in der jeweiligen Bedarfsposition unmittelbar aneinander oder über zwischengelegte Abstandsstücke (34) stapelartig abstützen und relativ zur Grundplatte 11 lösbar festlegbar sind.

11. Anordnung nach Anspruch 10, dadurch gekennzeichnet, daß die Fixierschienen (33) an ihren Enden (37) lösbar mit auf der Grundplatte (11) befestigten Stützböcken (40) verbunden sind.

12. Anordnung nach Anspruch 11, dadurch gekennzeichnet, daß die Stützböcke (40) parallel zueinander verlaufende Haltenuten (41) aufweisen, in die die Fixierschienen (33) mit abgesetzten Endbereichen (37) eingreifen.

13. Anordnung nach Anspruch 12, dadurch gekennzeichnet, daß am Grund jeder Haltenut (41) ein Langloch (42) für den Durchtritt einer in eine Gewindebohrung (39) an der Stirnseite des jeweiligen Endbereichs (37) eindrehbaren Schraube vorhanden ist.

14. Anordnung nach einem der Ansprüche 10 bis 13, dadurch gekennzeichnet, daß die Fixierschienen (33) an einer oder mehreren Stellen im Bereich zwischen ihren Enden mit der Grundplatte (11) verspannbar sind.

15. Anordnung nach Anspruch 14, gekennzeichnet durch wenigstens eine Spannvorrichtung (36), die mit einem Fußteil in einer T-Nut (45) der Grundplatte (11) oder einem mit dieser verbundenen Teil (35) verschiebbar ist und die eine zum Angriff an der obersten Fixierschiene (33) oder einem an oberster Stelle befindlichen Abstandsstück (34) dienende Spannpratze (46) aufweist.

16. Anordnung nach einem der Ansprüche 10 bis 15, dadurch gekennzeichnet, daß die Halteschuhe (31) jeweils eine zum Übergreifen des Randes einer Platine (P1, P2, P3, P4, P5) geeignete Ausnehmung (51) aufweisen, die unsymmetrisch zur Mittelebene (M) des Führungsteiles (31a) des Halteschuhes (31) liegt, derart, daß sich durch Umsetzen des Halteschuhes (31) um 180° in der Führung (32) der Fixierschiene (33) unterschiedliche Positionen der Ausnehmung (51) mit Bezug auf die Fixierschiene (33) ergeben.

17. Anordnung nach einem der Ansprüche 10 bis 16, dadurch gekennzeichnet, daß die Halteschuhe (31) eine im wesentlichen T-förmige Grundgestalt haben, wobei der T-Balken (31a) einen von der Führung (32) der Fixierschiene (33) aufzunehmenden Teil bildet und der Steg (31b) am freien Ende mit der Ausnehmung (51) versehen ist.

18. Anordnung nach einem der Ansprüche 10 bis 17, dadurch gekennzeichnet, daß wenigstens eine Fixierschiene (33) einen quer von ihr abstehenden Arm (55) aufweist, der mit einer Halterung (58) für eine weitere Kante einer Platine (P1, P2, P3, P4, P5) versehen ist oder eine solche bildet.

19. Anordnung nach Anspruch 18, gekennzeichnet durch ein an die Fixierschiene (33) angeschraubtes Winkelstück (56) mit einem eine Nut (57) aufweisenden Haltekörper (58).

20. Anordnung nach einem oder mehreren der voraufgehenden Ansprüche, dadurch gekennzeichnet, daß in einer im Winkel zu der Grundplatte (11) stehenden Stirnwand (12 bzw. 13) wenigstens ein Kühlluft-Gebläse (18) vorgesehen ist.

21. Anordnung nach Anspruch 20, dadurch gekennzeichnet, daß in einer zweiten im Winkel zu der Grundplatte (11) stehenden Stirnwand (12 bzw. 13) ebenfalls ein Kühlluft-Gebläse (18) oder eine Luftaustritts-Öffnung (19) vorgesehen ist.

22. Anordnung nach einem der Ansprüche 1 bis 21 mit wenigstens einer der Grundplatte benachbarten und sich parallel zu dieser erstreckenden Platine, dadurch gekennzeichnet, daß zwischen dieser Platine (P1) bzw. darauf befindlichen Elementen und der Grundplatte (11) wenigstens ein mit diesen beiden Teilen in Berührung stehender wärmeübertragender Körper (61) vorgesehen ist.

## Claims

1. A multichip carrier arrangement for computers and similar electronic equipment, the multichip carriers (P1, P2, P3, P4, P5) each being provided on one border with at least one contact strip (22) and extending at right angles to a card component (20) which is disposed orthogonally to a base and in a fixed manner relative thereto and forms a bus carrier which, on each side, has edge connectors (21) for the contact strips (22) of the multichip carriers (P1, P2, P3, P4, P5), characterised by the following features:
- at least on one card side (I and/or II) of the bus carrier (20) there is disposed at least one edge connector (21) for a multichip carrier (P1, P2, P3, P4, P5) in one half-region (IA or IB and/or IIA or IIB) of the said card side (I and/or II) and at least one edge connector (21) for another multichip carrier (P1, P2, P3, P4, P5) in the other half-region (IB or IA and/or IIB or IIA) of the said card side (I and/or II),
- the half-regions (IA, IB and/or IIA, IIB) of the bus carrier (20) being adjacent in the direction of the edge connectors (21),
- the edge connectors (21) in the one half-region (IA and/or IIA) of the card side (I and/or II) and the edge connectors (21) in the other half-region (IB and/or IIB) are mutually offset in the height direction (H), which extends perpendicularly to the direction of the edge connectors, of the bus carrier (20).

2. An arrangement as claimed in claim 1, characterised in that edge connectors (21) on the one card side (I or II) of the bus carrier (20) are offset relative to edge connectors (21) on the other card side (II or I) of the bus carrier (20) in the height direction (H) of the bus carrier (20).

3. An arrangement as claimed in claim 1 or 2, characterised in that at least one edge connector (21) on the one card side (I or II) of the bus carrier (20) is disposed at least approximately at the same height as at least one edge connector (21) on the other card side (II or I) of the bus carrier (20).

4. An arrangement as claimed in claim 3, characterised in that the edge connectors (21) disposed at least approximately at the same height on the two card sides (I, II) of the bus carrier (20) are provided in different half-regions (A, B) of the two card sides (I, II) of the bus carrier (20).

5. An arrangement as claimed in one of claims 1 to 4, characterised in that at least some of the edge connectors (21) in one half-region (A) of one card side (I) of the bus carrier (20) are at a greater distance (a) from one border (25) of the bus carrier (20) than are at least some of the edge connectors (21) in the other half-region (B) of the same card side (I) of the bus carrier (20) from the same border (25) of the bus carrier (20).

6. An arrangement as claimed in one of claims 1 to 5, characterised in that the bus carrier (20) has not only edge connectors (21) but also at least one holding device (23) which is designed as a slotted strip to accommodate the border of a multichip carrier (P1, P2, P3, P4, P5).

7. An arrangement as claimed in claim 6, characterised in that, on the bus carrier (20), there is provided at least one holding device (23) approximately in the same plane as an edge connector (21).

8. An arrangement as claimed in claim 6, characterised in that, on the bus carrier (20), there is provided at least one holding device (23) in a plane offset relative to the plane of an edge connector (21).

9. An arrangement as claimed in one of claims 6 to 8, characterised in that, on one card side (I or II) of the bus carrier (20), there is provided at least one holding device (23) in a region in which an edge connector (21) is disposed on the other card side (II or I) of the bus carrier (20).

10. An arrangement as claimed in one of claims 1 to 9, characterised in that at least some of the multichip carriers (P1, P2, P3, P4, P5) present can be supported on a border on the opposite side to the bus carrier (20) by means of holding fitments (31) which are movable in guides (32) of positioning rails (33) which are disposed one above the other, are supported in the respectively required position in a stack-like manner either directly on each other or by means of sandwiched distance pieces (34), and which can be temporarily fixed relative to the base 11.

11. An arrangement as claimed in claim 10, characterised in that the positioning rails (33) are temporarily connected at their ends (37) to supporting frames (40) secured to the base (11).

12. An arrangement as claimed in claim 11, characterised in that the supporting frames (40) have holding grooves (41) which extend in a mutually parallel fashion and in which the positioning rails (33) engage with shouldered end regions (37).

13. An arrangement as claimed in claim 12, characterised in that, in the bottom of each holding groove (41), there is provided an elongated hole (42) to allow the passage of a screw which can be screwed into a threaded hole (39) on the face of the respective end region (37).

14. An arrangement as claimed in one of claims 10 to 13, characterised in that the positioning rails (33) can be braced against the base (11) at one or more points in the region between their ends.

15. An arrangement as claimed in claim 14, characterised by at least one gripping device (36) which, with a foot portion, is movable in a T-slot (45) of the base (11) or in a component (35) connected thereto, and which has a gripping bracket (46) for engagement in the uppermost positioning rail (33) or in a distance piece (34) disposed at the uppermost point.

16. An arrangement as claimed in one of claims 10 to 15, characterised in that the holding fitments (31) each have a recess (51) suitable for overlapping the border of a multichip carrier (P1, P2, P3, P4, P5), which recess is disposed asymmetrically to the centre plane (M) of the guide portion (31a) of the holding fitment (31) such that rotation of the holding fitment (31) around 180° in the guide (32) of the positioning rail (33) produces different positions of the recess (51) with reference to the positioning rail (33).

17. An arrangement as claimed in one of claims 10 to 16, characterised in that the holding fitments (31) have a substantially T-shaped basic design, the T-beam (31a) forming a portion to be accommodated by the guide (32) of the positioning rail (33) and the fin (31b) at the free end being provided with the recess (51).

18. An arrangement as claimed in one of claims 10 to 17, characterised in that at least one positioning rail (33) has an arm (55) which projects therefrom at right angles and which is provided with or forms a holding device (58) for a further edge of a multichip carrier (P1, P2, P3, P4, P5).

19. An arrangement as claimed in claim 18, characterised by an elbow (56) which is screwed onto the positioning rail (33) and has a holding body (58) with a slot (57).

20. An arrangement as claimed in one or more of the preceding claims, characterised in that in one end wall (12 or 13), which is at an angle to the base (11), there is provided at least one cooling-air blower (18).

21. An arrangement as claimed in claim 20, characterised in that, in a second end wall (12 or 13) which is at an angle to the base (11), there is likewise provided a cooling-air blower (18) or an air outlet aperture (19).

22. An arrangement as claimed in one of claims 1 to 21 with at least one multichip carrier adjacent to the base and extending parallel thereto, characterised in that, between this multichip carrier (P1) and/or modules disposed thereon and the base (11), there is provided at least one heat transfer body (61) which is in contact with these two components.

## Revendications

1. Dispositif à cartes pour ordinateurs et appareils électroniques semblables, dans lequel des cartes (P1,P2,P3,P4,P5) comportant sur un bord respectivement au moins une barrette de contact (22), s'étendent transversalement par rapport à un composant en forme de plaque (20), qui pour sa part est disposé perpendiculairement à une plaque de base et de façon fixe par rapport à cette dernière et forme une carte de bus, qui possède, de chaque côté, des barrettes d'enfichage (21) pour les barrettes de contact (22) des cartes (P1,P2,P3,P4,P5), caractérisé par les caractéristiques suivantes :
- au moins sur une face (I) ou (II) de la plaque de la carte de bus (20), au moins une barrette d'enfichage (21) pour une carte (P1,P2,P3,P4,P5) est disposée dans une moitié (IA ou IB ou IIA ou IIB) de cette face (I ou II) de la plaque et au moins une barrette d'enfichage (21) pour une autre carte (P1,P2,P3,P4,P5) est disposée dans l'autre moitié (IB ou IA ou IIB ou IIA) de cette face (I et II) de la plaque,
- les moitiés (IA, IB ou IIA, IIB) de la carte de bus (20) sont disposées côte-à-côte - lorsqu'on regarde dans la direction des barrettes d'enfichage (21),
- les barrettes d'enfichage (21) dans une moitié (IA ou IIA) de la face (I ou II) de la plaque et les barrettes d'enfichage (21) dans l'autre moitié (IB ou IIB) sont décalées réciproquement dans le sens de la hauteur (H), qui est perpendiculaire à la direction des barrettes d'enfichage, de la carte de bus (20).

2. Dispositif selon la revendication 1, caractérisé en ce que des barrettes d'enfichage (21) située sur une face (I ou II) de la plaque de la carte de bus (20) sont décalées par rapport à des barrettes d'enfichage (21) situées sur l'autre face (II ou I) de la plaque de la carte de bus (20), dans le sens de la hauteur (H) de la carte de bus (20).

3. Dispositif selon la revendication 1 ou 2, caractérisé en ce qu'au moins une barrette d'enfichage (21) est située sur une face (I ou II) de la plaque de la carte de bus (20) est disposée au moins approximativement à la même hauteur qu'au moins une barrette d'enfichage (21) située sur l'autre face (II ou I) de la plaque de la carte de bus (20).

4. Dispositif selon la revendication 3, caractérisé en ce que les barrettes d'enfichage (21), disposées au moins approximativement à la même hauteur sur les deux faces (I, II) de la plaque de la carte de bus (20), sont prévues dans différentes moitiés (A, B) des deux faces (I, II) de la plaque de la carte de bus (20).

5. Dispositif selon l'une des revendications 1 à 5, caractérisé en ce qu'au moins une partie des barrettes d'enfichage (21) dans une moitié (A) d'une face (I) de la plaque de la carte de bus (20) est située à une distance plus grande (a) d'un bord (25) de la carte de bus (20), au'au moins une partie des barrettes d'enfichage (21) est située dans l'autre moitié (B) de la même face (I) de la plaque de la carte de bus (20) par rapport au même bord (25) de la carte de bus (20).

6. Dispositif selon l'une des revendications 1 à 5, caractérisé en ce que la carte de bus (20) comporte non seulement des barrettes d'enfichage (21) mais aussi au moins un support (23), agencé sous la forme d'une barrette rainurée, pour le bord d'une carte (P1,P2,P3,P4,P5).

7. Dispositif selon la revendication 6, caractérisé en ce que sur la carte de bus (20) est prévue au moins un dispositif de retenue (23) situé au moins approximativement dans le même plan qu'une barrette d'enfichage.

8. Dispositif selon la revendication 6, caractérisé en ce que sur la carte de bus (20) est prévue au moins un dispositif de retenue (23) situé dans un plan décalé par rapport au plan d'une barrette d'enfichage.

9. Dispositif selon l'une des revendications 6 à 8, caractérisé en ce que sur une face (I ou II) de la plaque de la carte de bus (20), au moins un dispositif de retenue (23) est prévu dans une zone, dans laquelle une barrette d'enfichage (21) est située sur l'autre face (II ou I) de la plaque de la platine de bus (20).

10. Dispositif selon l'une des revendications 1 à 9, caractérisé en ce qu'au moins quelques-unes des cartes présentes (P1,P2,P3,P4,P5) peuvent être supportées, sur un bord tourné à l'opposé de la carte de bus (20), par des patins de retenue (31), qui peuvent être déplacés dans des guides (32) de rails de fixation (33) superposés, qui, dans la position requise respective, prennent appui, à la manière d'un empilage, directement les uns sur les autres ou au moyen de l'interposition d'entretoises (34) et peuvent être fixés de façon amovible par rapport à la plaque de base (11).

11. Dispositif selon la revendication 10, caractérisé en ce que les rails de fixation (33) sont reliés de façon amovible, au niveau de leurs extrémités (37), à des blocs d'appui (40) fixés à la plaque de base (11).

12. Dispositif selon la revendication 11, caractérisé en ce que les blocs d'appui (40) comportent des rainures de retenue parallèles (41), dans lesquelles les rails de fixation (33) s'engagent par des parties d'extrémité étagées (37).

13. Dispositif selon la revendication 12, caractérisé en ce que dans le fond de chaque rainure de retenue (41) est prévu un trou allongé (42), permettant le passage d'une vis, qui peut être vissée dans un perçage taraudé (39) situé dans la face frontale de la partie d'extrémité respective (37).

14. Dispositif selon l'une des revendications 10 à 13, caractérisé en ce que les rails de fixation (33) peuvent être serrés sur la plaque de base (11) en un ou plusieurs endroits dans la zone située entre ses extrémités.

15. Dispositif selon la revendication 14, caractérisé par au moins un dispositif de serrage (36), qui est déplaçable avec une partie formant pied dans une rainure en T (45) de la plaque de base (11) ou avec une partie (35) reliée à cette dernière, et comporte une griffe de serrage (46), qui est destinée à s'accrocher au rail de fixation le plus élevé (33) ou à une entretoise (34) située à l'emplacement le plus élevé.

16. Dispositif selon l'une des revendications 10 à 15, caractérisé en ce que les patins de retenue (31) possèdent chacun un évidement (51), qui est approprié pour s'engager sur le bord d'une carte (P1,P2,P3,P4,P5) et qui est disposé de façon dissymétrique par rapport au plan médian (M) de la partie de guidage (31a) du patin de retenue (31) de telle sorte que sous l'effet du pivotement du patin de retenue (31) sur 180° dans le guide (32) du rail de fixation (33) on obtient, pour l'évidement (51), différentes positions par rapport au rail de fixation (33).

17. Dispositif selon l'une des revendications 10 à 16, caractérisé en ce que les patins de retenue (31) possèdent une configuration de base essentiellement en forme de T, la barre (31a) du T formant une partie servent à se loger dans le guide (32) du rail du fixation (33), tandis que le pied (31b) comporte l'évidement (51) au niveau de son extrémité libre.

18. Dispositif selon l'une des revendications 10 à 17, caractérisé en ce qu'au moins un rail de fixation (33) possède un bras (55), qui est disposé transversalement en saillie et comporte ou forme un support (58) pour un autre bord d'une carte (P1,P2,P3,P4,P5).

19. Dispositif selon la revendication 18, caractérisé par une cornière (56) vissée au rail de fixation (33) et comportant un corps de retenue (58) possédant une rainure (57).

20. Dispositif selon une ou plusieurs des revendications précédentes, caractérisé en ce qu'au moins un ventilateur (18) délivrant un air de refroidissement est prévu dans une paroi frontale (12 ou 13) qui est inclinée par rapport à la plaque de base (11).

21. Dispositif selon la revendication 20, caractérisé en ce qu'un ventilateur (18) délivrant un air de refroidissement ou une ouverture de sortie d'air (19) est également prévu dans une seconde paroi frontale (12 ou 13) qui fait un angle par rapport à la plaque de base (11).

22. Dispositif selon la revendication 1 à 21, comportant au moins une carte, qui est voisine de la plaque de base et s'étend parallèlement à cette dernière, caractérisé en ce qu'entre cette carte (P1) ou des éléments situés sur cette carte et la plaque de base (11) est prévu au moins un corps (61) qui est en contact avec ces deux parties et réalise un transfert thermique.
